# EUROPEAN PATENT APPLICATION

(11) **EP 4 742 494 A1**
(43) Date of publication of application: **13.05.2026**
(21) Application number: 25213338.4
(22) Date of filing: 04.11.2025
(51) Int. Cl.: H02J 7/61, H02J 7/63, H02J 7/80, H02J 7/84, H02J 7/90, H02J 7/96, G01R 31/389, H01M 10/44, H01M 10/48, H02J 7/82

(54) **BATTERY MANAGEMENT SYSTEM AND BATTERY MANAGEMENT METHOD**

(30) Priority: 08.11.2024 KR 20240157622
(71) Applicant: SAMSUNG SDI CO., LTD., Yongin-si, Gyeonggi-do 17084 (KR)
(72) Inventor: SEOL, Junha, 17084 Yongin-si (KR)
(74) Representative: Marks & Clerk LLP

(57) **Abstract**

A battery management system (300) includes an impedance measurement unit (310) configured to measure at least one of an impedance of a battery (400) for each charging cycle or an impedance of the battery (400) for each discharging cycle, and a battery control unit (330) configured to perform at least one of calculating an amount of change in a charging impedance by comparing an impedance of a current charging cycle with an impedance of a previous charging cycle, and setting a next discharging completion voltage of the battery (400) based on the amount of change in the charging impedance, or calculating an amount of change in a discharging impedance by comparing an impedance of a current discharging cycle with an impedance of a previous discharging cycle, and setting a next charging completion voltage of the battery (400) based on the amount of change in the discharging impedance.

## Description

### FIELD

Aspects of embodiments of the present disclosure relate to a battery management system and a battery management method.

### BACKGROUND

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

Energy storage systems (ESS) can connect renewable energy sources such as wind, solar power, or the like, whose power generation output cannot be controlled, to an existing power grid and charge or discharge energy according to the power consumption pattern. In particular, a battery energy storage system using secondary batteries can not only be used to stabilize system voltage and frequency, but also store surplus energy in conjunction with a renewable energy generation system whose power generation output is not consistent, such as wind, solar power, or the like, and discharge the energy stored in the batteries to supply energy to loads.

In an energy storage system, efficient management of the batteries is one of the important factors. By managing various matters such as charging, discharging, and cell balancing of the batteries, the service life of the batteries can be extended, and power can be stably supplied to loads. To this end, the energy storage system may include a battery management system (BMS).

There is a fire risk due to deterioration if the batteries are overcharged or overdischarged. The battery management system needs to manage the batteries to ensure that the batteries are not overcharged or overdischarged.

The herein information disclosed in this Background section is for enhancement of understanding of the background of the present disclosure, and therefore, it may contain information that does not constitute related (or prior) art.

### SUMMARY

Embodiments of the present disclosure provide a battery management system and a battery management method to solve the herein problem.

However, the technical problem to be solved by the present disclosure is not limited to the herein problem, and other problems not mentioned herein, and aspects and features of the present disclosure that would address such problems, will be clearly understood by those skilled in the art from the description of the present disclosure herein.

According to embodiments of the present disclosure to solve the herein technical problem, a battery management system may include an impedance measurement unit configured to measure at least one of an impedance of a battery for each charging cycle or an impedance of the battery for each discharging cycle, and a battery control unit configured to perform at least one of calculating an amount of change in a charging impedance by comparing an impedance of a current charging cycle with an impedance of a previous charging cycle, and setting a next discharging completion voltage of the battery based on the amount of change in the charging impedance, or calculating an amount of change in a discharging impedance by comparing an impedance of a current discharging cycle with an impedance of a previous discharging cycle, and setting a next charging completion voltage of the battery based on the amount of change in the discharging impedance.

According to one or more embodiments, the impedance measurement unit may measure impedances in preset frequency units by electrochemical impedance spectroscopy (EIS).

According to one or more embodiments, the battery control unit may compare a magnitude of an impedance for each preset frequency of an impedance for each current charging cycle with a magnitude of an impedance for each impedance for each preset frequency of an impedance for each previous charging cycle, calculate an average amount of change in a charging impedance of an amount of change of an impedance for said each preset frequency, and set the next discharging completion voltage based on the average amount of change in the charging impedance.

According to one or more embodiments, the battery control unit may decrease the next discharging completion voltage if the average amount of change in the charging impedance has increased.

According to one or more embodiments, the battery control unit may decrease the next discharging completion voltage by a preset rate from a current discharging completion voltage in inverse proportion to the average amount of change in the charging impedance.

According to one or more embodiments, the battery control unit may increase the next discharging completion voltage if the average amount of change in the charging impedance has decreased.

According to one or more embodiments, the battery control unit may increase the next discharging completion voltage by a preset rate from a current discharging completion voltage in inverse proportion to the average amount of change in the charging impedance.

According to one or more embodiments, the battery control unit may compare a magnitude of an impedance for each preset frequency of an impedance for each current discharging cycle with a magnitude of an impedance for each impedance for each preset frequency of an impedance for each previous discharging cycle, calculate an average amount of change in a discharging impedance of an amount of change of an impedance for said each preset frequency, and set the next charging completion voltage of the battery based on the average amount of change in the discharging impedance.

According to one or more embodiments, the battery control unit may increase the next charging completion voltage if the average amount of change in the discharging impedance has increased.

According to one or more embodiments, the battery control unit may increase the next charging completion voltage by a preset rate from a current discharging completion voltage in proportion to the average amount of change in the discharging impedance.

According to one or more embodiments, the battery control unit may decrease the next charging completion voltage if the average amount of change in the discharging impedance has decreased.

According to one or more embodiments, the battery control unit may decrease the next charging completion voltage by a preset rate from a current discharging completion voltage in proportion to the average amount of change in the discharging impedance.

According to one or more embodiments, the battery control unit may set a first charging impedance of the battery measured when the battery is first charged after being shipped as a basic charging impedance, set a voltage measured after the first charging is completed as a basic charging completion voltage, and set the next charging completion voltage to be lower than the basic charging completion voltage.

According to one or more embodiments, the battery control unit may set a first discharging impedance of the battery measured when the battery is first discharged after being initially charged as a basic discharging impedance, set a voltage measured after the first discharging is completed as a basic discharging completion voltage, and set the next discharging completion voltage to be higher than the basic discharging completion voltage.

According to one or more embodiments of the present disclosure, a method of managing a battery may include measuring at least one of an impedance of a battery for each charging cycle or an impedance of the battery for each discharging cycle, performing at least one of calculating an amount of change in a charging impedance by comparing an impedance of a current charging cycle with an impedance of a previous charging cycle, and setting a next discharging completion voltage of the battery based on the amount of change in the charging impedance, or calculating an amount of change in a discharging impedance by comparing an impedance of a current discharging cycle with an impedance of a previous discharging cycle, and setting a next charging completion voltage of the battery based on the amount of change in the discharging impedance and terminating charging of the battery when the battery is charged or reaches the next charging completion voltage, or terminating discharging of the battery when the battery is discharged or reaches the next discharging completion voltage.

According to one or more embodiments, the measuring the impedance of the battery may include measuring impedances in preset frequency units by electrochemical impedance spectroscopy (EIS).

According to one or more embodiments, the setting the next discharging completion voltage may include comparing a magnitude of an impedance for each preset frequency of an impedance for each current charging cycle with a magnitude of an impedance for each impedance for each preset frequency of an impedance for each previous charging cycle, calculating an average amount of change in a charging impedance of an amount of change of an impedance for said each preset frequency, and setting the next discharging completion voltage based on the average amount of change in the charging impedance.

According to one or more embodiments, the setting the next discharging completion voltage may include decreasing the next discharging completion voltage if the average amount of change in the charging impedance has increased and increasing the next discharging completion voltage if the average amount of change in the charging impedance has decreased.

According to one or more embodiments, the setting the next charging completion voltage may include comparing a magnitude of an impedance for each preset frequency of an impedance for each current discharging cycle with a magnitude of an impedance for each impedance for each preset frequency of an impedance for each previous discharging cycle, calculating an average amount of change in a discharging impedance of an amount of change of an impedance for said each preset frequency, and setting the next charging completion voltage of the battery based on the average amount of change in the discharging impedance.

According to one or more embodiments, the setting the next charging completion voltage may include increasing the next charging completion voltage if the average amount of change in the discharging impedance has increased and decreasing the next charging completion voltage if the average amount of change in the discharging impedance has decreased.

According to some embodiments of the present disclosure, precise charging and discharging voltages can be controlled by analyzing electrochemical impedances.

According to some embodiments of the present disclosure, overcharging and overdischarging of a battery can be prevented by adjusting the charging completion voltage and discharging completion voltage of the battery based on the amount of change in the battery charging/discharging impedance in the current time point and the battery charging/discharging impedance in the previous time point.

However, aspects and features of the present disclosure are not limited to those described herein, and other aspects and features not mentioned will be clearly understood by a person skilled in the art from the detailed description, described herein.

At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
FIG. 1 is a diagram showing an energy storage system according to embodiments of the present disclosure.
FIG. 2 is a diagram showing a battery and a battery management system according to embodiments of the present disclosure.
FIG. 3 is a diagram showing the configuration of a battery management system according to embodiments of the present disclosure.
FIG. 4 is a diagram showing a battery equivalent circuit taking into account the electrochemical properties of a battery according to embodiments of the present disclosure.
FIG. 5 is a graph showing a currently measured charging impedance and a previously measured charging impedance by electrochemical impedance spectroscopy according to embodiments of the present disclosure.
FIG. 6 is a table showing the amount of change in the magnitude of the current charging impedance and the magnitude of the previous charging impedance shown in FIG. 5.
FIG. 7 and FIG. 8 are diagrams showing a method in which a battery management system sets a discharging completion voltage according to embodiments of the present disclosure.
FIG. 9 and FIG. 10 are diagrams showing a method in which a battery management system sets a charging completion voltage according to embodiments of the present disclosure.
FIG. 11 is a diagram showing a battery management method according to embodiments of the present disclosure.

### DETAILED DESCRIPTION

Hereinafter, embodiments of the present disclosure will be described, in detail, with reference to the accompanying drawings. The terms or words used in the present specification and claims are not to be limitedly interpreted as general or dictionary meanings and should be interpreted as meanings and concepts that are consistent with the technical idea of the present disclosure on the basis of the principle that an inventor can be his/her own lexicographer to appropriately define concepts of terms to describe his/her disclosure in the best way.

The embodiments described in this specification and the configurations shown in the drawings are only some of the embodiments of the present disclosure and do not represent all of the aspects and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

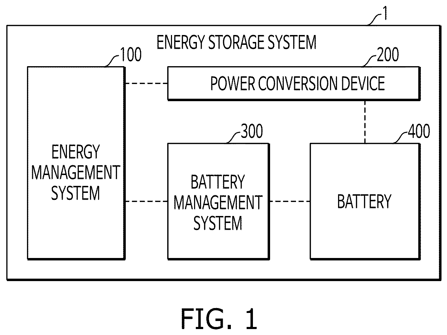

FIG. 1 is a diagram showing an energy storage system according to embodiments of the present disclosure.

Referring to FIG. 1, an energy storage system (ESS) 1 according to embodiments of the present disclosure may include an energy management system (EMS) 100, a power conversion system (PCS) 200, a battery management system (BMS) 300, and a battery 400. For example, the energy storage system 1 may be a device capable of storing and supplying electricity, such as a power commerce ESS device, an uninterrupted power supply device, or a home ESS device, but is not limited thereto.

According to embodiments, the energy management system 100 may control all operations of the energy storage system 1 and monitor in real-time where the energy is used and the amount consumed. The energy management system 100 may receive the charging and discharging states of the battery 400 from the battery management system 300. The energy management system 100 may monitor the charging and discharging states of the battery 400 and control the battery 400 to charge or discharge power via the power conversion device 200.

For example, the energy management system 100 may control the battery 400 to be charged via the power conversion device 200 with renewable energy such as wind or solar power, etc., as a power source. The energy management system 100 may control the power stored in the battery 400 to be discharged via the power conversion device 200 so that the power can be supplied to loads such as household appliances or factory equipment.

According to embodiments, the power conversion device 200 may be a device capable of converting from AC to DC and from DC to AC. For example, the power conversion device 200 may convert AC power generated from solar power generation, wind power generation, etc., into DC power and transfer it to the battery 400. As another example, the power conversion device 200 may convert DC power stored in the battery 400 into AC power and supply it to a load.

According to embodiments, the battery management system 300 may manage various matters such as charging, discharging, and cell balancing of the battery 400. For example, the battery management system 300 may monitor the voltage, current, temperature, etc., of the battery 400 measured via sensors, or the like. The battery management system 300 may monitor the charging state of the battery 400 and reduce the variation in charging voltage among a plurality of battery cells. The battery management system 300 may control the charging and discharging of the battery 400 so that the battery 400 does not suffer from overcharge, overdischarge, overcurrent, or the like.

According to embodiments, the battery 400 may be charged with and store power generated from a power generation system such as wind power generation or solar power generation by the control of the battery management system 300, and discharge and supply power to loads such as household appliances or factory equipment.

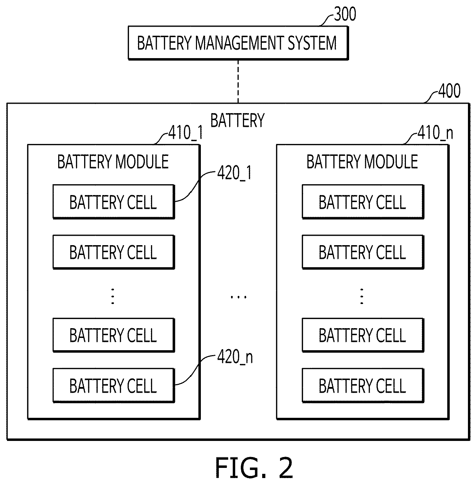

FIG. 2 is a diagram showing a battery and a battery management system according to embodiments of the present disclosure.

Referring to FIG. 2, the battery 400 and the battery management system 300 are shown as physically independent components but are not limited thereto, and the battery management system 300 may be incorporated into and arranged in the battery 400 in a pack unit or a rack unit.

According to embodiments, the battery 400 may include a plurality of battery modules 410_1 to 410_n, each including a plurality of battery cells 420_1 to 420_n. The plurality of battery cells 420_1 to 420_n may be rechargeable secondary batteries. The number and connection method of the battery cells included in the battery 400 may be determined based on the required electrical energy, voltage, etc.

According to embodiments, the battery 400 may be formed in battery rack units that house a single battery pack or a plurality of battery packs depending on the design conditions of the energy storage system 1 (see FIG. 1), but is not limited thereto.

According to embodiments, the battery management system 300 may be a device for measuring the voltage, current, temperature, etc., of the battery 400 and controlling the charging and discharging of the battery 400. The battery management system 300 may be a device that measures the voltage, current, temperature, etc., of each of the plurality of battery modules 410_1 to 410_n and controls charging and discharging thereof, or measures the voltage, current, temperature, etc., of the entire battery 400 in pack units or rack units and controls charging and discharging thereof. For example, the battery management system 300 may include, but is not limited to, a master control unit (e.g., a system BMS) that controls the charging and discharging of the entire battery 400 and a plurality of slave control units (e.g., rack BMS or module BMS) that controls the charging and discharging of each of the plurality of battery modules 410_1 to 410_n.

According to embodiments, the battery management system 300 may measure the impedance of the battery 400 for each charging cycle or discharging cycle of the battery 400. The impedance of the battery 400 may be for one of a cell unit, a module unit, a pack unit, and a rack unit, but is not limited thereto. The impedance for each charging or discharging cycle may be an impedance measured immediately after charging or immediately after discharging but is not limited thereto, and may also be an impedance measured during charging or discharging.

According to embodiments, the battery management system 300 may calculate an impedance change rate by comparing the impedance of the current charging cycle with the impedance of the immediately preceding charging cycle. When the battery 400 that has completed the current charging is discharged, the battery management system 300 may reset the voltage at which the discharging is to be completed (a next discharging completion voltage) based on the impedance change rate. If the voltage measured when the battery 400 is discharged reaches the reset discharging completion voltage, the battery management system 300 may stop discharging the battery 400.

According to embodiments, the battery management system 300 may calculate an impedance change rate by comparing the impedance of the current discharging cycle with the impedance of the immediately preceding discharging cycle. When the battery 400 that has completed the current discharging is charged, the battery management system 300 may reset the voltage at which the charging is to be completed (a next charging completion voltage) based on the impedance change rate. If the voltage measured when the battery 400 is charged reaches the reset charging completion voltage, the battery management system 300 may stop charging the battery 400.

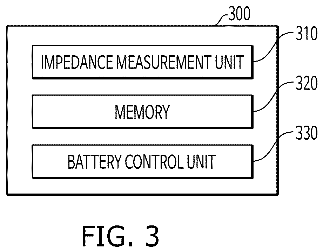

FIG. 3 is a diagram showing the configuration of a battery management system according to embodiments of the present disclosure.

Referring to FIG. 3, the battery management system 300 according to embodiments of the present disclosure may include an impedance measurement unit 310, a memory 320, and a battery control unit 330.

According to embodiments, the impedance measurement unit 310 may measure at least one of the impedance of the battery 400 (see FIG. 2) for each charging cycle or the impedance of the battery 400 for each discharging cycle. The impedance measurement unit 310 may measure the impedance of the battery 400 in at least one unit of a cell unit, a module unit, a pack unit, and a rack unit, but is not limited thereto.

According to embodiments, the impedance measurement unit 310 may measure impedances in preset frequency units through electrochemical impedance spectroscopy (EIS). The impedance measurement unit 310 may measure the impedance of the battery 400 for each charging cycle in preset frequency units or the impedance of the battery 400 for each discharging cycle in preset frequency units.

According to embodiments, the memory 320 may include any non-transitory computer-readable recording medium. For example, the memory 320 may include, but is not limited to, a permanent mass storage device such as a read-only memory (ROM), a disk drive, a solid-state drive (SSD), a flash memory, etc. The memory 320 may store an operating system and at least one program code. For example, the memory 320 may have one or more instructions (program codes) stored therein for performing a method of charging and discharging the battery 400 according to embodiments of the present disclosure.

According to embodiments, the memory 320 may store the impedance of the battery 400 for each charging cycle or the impedance of the battery 400 for each discharging cycle measured by the impedance measurement unit 310. The battery control unit 330 may reset the charging completion voltage or discharging completion voltage of the battery 400 for each charging or discharging cycle based on the impedance of the battery 400 stored in the memory 320.

According to embodiments, the battery control unit 330 may control the charging and discharging of the battery 400. For example, the battery control unit 330 may control the charging or discharging operation of the battery 400 by controlling the operation of a relay connected between the battery 400 and the power conversion device 200 (see FIG. 1), but is not limited thereto. The battery control unit 330 may set the charging completion voltage and the discharging completion voltage. When the battery 400 is charged, the battery control unit 330 may control the charging operation of the battery 400 so that the charging is stopped when the voltage of the battery 400 reaches the charging completion voltage. When the battery 400 is discharged, the battery control unit 330 may control the discharging operation of the battery 400 so that the discharging is stopped when the voltage of the battery 400 reaches the discharging completion voltage.

According to embodiments, the battery control unit 330 may calculate the amount of change in the charging impedance of the battery 400 by comparing the impedance of the battery 400 in the current charging cycle with the impedance of the battery 400 in the previous charging cycle. The battery control unit 330 may perform setting the next discharging completion voltage of the battery 400 based on the amount of change in the charging impedance of the battery 400.

The battery control unit 330 may calculate the amount of change in the discharging impedance of the battery 400 by comparing the impedance of the battery 400 in the current discharging cycle with the impedance of the battery 400 in the previous discharging cycle. The battery control unit 330 may perform setting the next charging completion voltage of the battery 400 based on the amount of change in the discharging impedance of the battery 400.

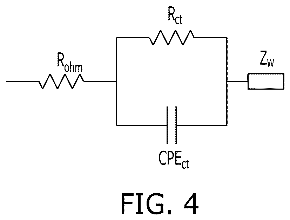

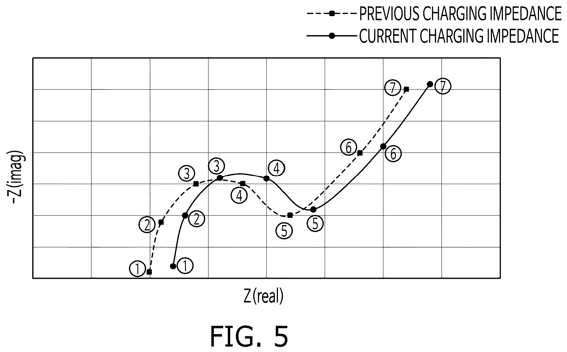

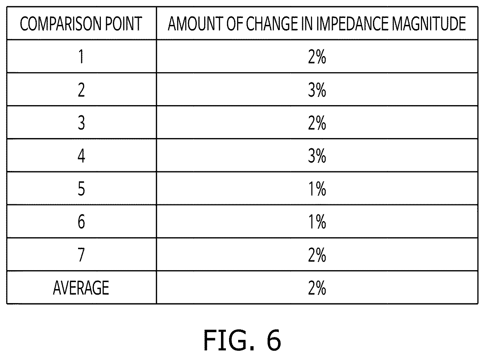

FIG. 4 is a diagram showing a battery equivalent circuit taking into account the electrochemical properties of a battery according to embodiments of the present disclosure. FIG. 5 is a graph showing a currently measured charging impedance and a previously measured charging impedance by electrochemical impedance spectroscopy according to embodiments of the present disclosure. FIG. 6 is a table showing the amount of change in the magnitude of the current charging impedance and the magnitude of the previous charging impedance shown in FIG. 5.

Referring to FIG. 4, the impedance measurement unit 310 (see FIG. 3) according to embodiments of the present disclosure may measure the charging impedance or discharging impedance of the battery 400 by electrochemical impedance spectroscopy. The electrochemical impedance spectroscopy takes into account the electrochemical properties of the battery 400, and may simply represent the impedance of the battery 400 with an equivalent circuit.

As a non-limiting example, the impedance equivalent circuit of the battery 400 may be composed of ohmic resistance Rohm, charge transfer resistance Rct, double layer capacitor CPEct, and dispersion impedance Zw elements, but is not limited thereto.

Here, the ohmic resistance Rohm may be the resistance obtained by adding all resistance components present in the electrolyte, current collector, separator, etc. Because the ohmic resistance Rohm is greatly affected by the electrolyte, the ionic conductivity of the electrolyte may increase as the temperature rises, and thus, the ohmic resistance Rohm may decrease. Because side reactions occur due to electrolyte decomposition when a battery deteriorates, and the ion conductivity decreases due to a decrease in the electrolyte, which results in a phenomenon in which the ohmic resistance Rohm increases, it can be used as an indicator of deterioration.

The charge transfer resistance Rct indicates a phenomenon that occurs when charges move at the electrode interface, and the double layer capacitor CPEct may be used as an indicator representing the phenomenon of an electric double layer occurring at the interface of an electrode and a solid electrolyte interphase (SEI), and the solid electrolyte interphase and the electrolyte.

The dispersion impedance Zw may be an indicator representing the diffusion phenomenon of lithium ions in the battery. The diffusion phenomenon results not from external electric fields but from internal concentration differences, and may occur when lithium ions move inside the electrode as charging and discharging proceeds. The dispersion impedance Zw may be used as an indicator representing a diffusion phenomenon that occurs due to a difference in the concentration of chemical species.

For example, the impedance measurement unit 310 may supply a predetermined current having a preset plurality of frequencies to the battery 400 and measure the impedance from the relationship with the voltage of the battery 400, immediately after the battery 400 has completed charging or discharging. The measured impedance of the battery 400 may be represented by a Nyquist diagram of impedance values having real and imaginary values according to the frequency change, as shown in FIG. 5.

Referring to FIGS. 5 and 6, the impedance value for each frequency at which charging is completed in the current cycle and the impedance value for each frequency at which charging was completed in the previous cycle may be represented by a Nyquist diagram, and the amount of change in the impedance for each frequency may be represented by a table.

The battery control unit 330 may compare the current charging impedance value with the previous charging impedance value for each preset frequency unit. For example, the battery control unit 330 may compare the charging impedance value of the current cycle with the charging impedance value of the previous cycle for each of the first to seventh frequencies. The amount of change in the charging impedance value of the current cycle may be calculated, respectively, by comparing it with the charging impedance value of the previous cycle for each of the first to seventh frequencies.

The battery control unit 330 may calculate the amount of change in the charging impedance calculated for each preset frequency as an average value. For example, the average amount of change in the charging impedance calculated for each of the first to seventh frequencies may be calculated to be an increase of 2%. The average amount of change in the charging impedance may be used as a factor that allows for setting the next discharging completion voltage value.

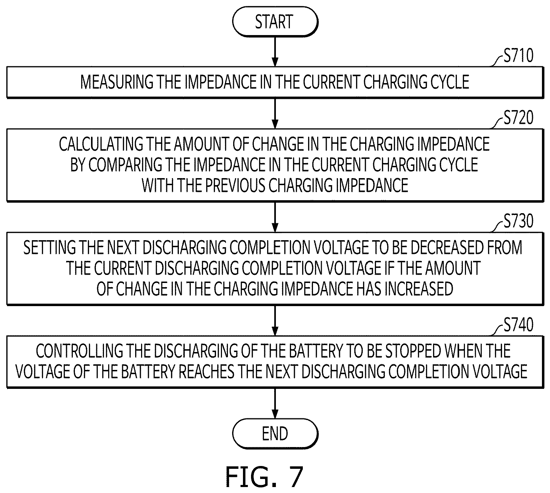

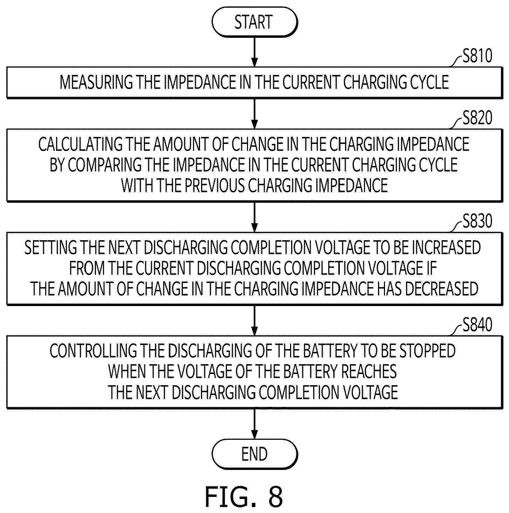

FIG. 7 and FIG. 8 are diagrams showing a method in which a battery management system sets a discharging completion voltage according to embodiments of the present disclosure.

Referring to FIG. 7, the impedance measurement unit 310 may measure the impedance of the battery 400 in the current charging cycle in step S710. For example, the impedance measurement unit 310 may measure the impedance of the battery 400 in preset frequency units immediately after the charging is completed.

In step S720, the battery control unit 330 may calculate the amount of change in the charging impedance by comparing the charging impedance in the current charging cycle with the charging impedance in the previous charging cycle. The battery control unit 330 may compare the magnitude of the impedance for each preset frequency of the current charging cycle with the magnitude of the impedance for each preset frequency of the previous charging cycle. The battery control unit 330 may calculate an average amount of change in the charging impedance for each preset frequency.

In step S730, the battery control unit 330 may set the next discharging completion voltage to be decreased from the current discharging completion voltage if the average amount of change in the charging impedance has increased. The battery control unit 330 may set the next discharging completion voltage to be decreased from the current discharging completion voltage by a preset rate in inverse proportion to the average amount of change in the charging impedance. For example, if the average amount of change in the charging impedance has increased by 2%, the battery control unit 330 may reset the discharging completion voltage in the next cycle to a value decreased by a rate of 0.2% from the discharging completion voltage in the current cycle, but is not limited thereto.

In step S740, the battery control unit 330 may control the discharging of the battery 400 to be stopped when the voltage of the battery 400 reaches the next discharging completion voltage. For example, the battery 400 may be discharged again after the charging is completed in the current cycle. The battery control unit 330 may control the discharging operation of the battery 400 so that the discharging of the battery 400 is stopped when the voltage of the battery 400 reaches the reset discharging completion voltage.

Referring to FIG. 8, steps S810, S820, and S840 are the same as steps S710, S720, and S740 described in FIG. 7, and thus, the overlapping descriptions will be omitted.

In step S830, the battery control unit 330 may set the next discharging completion voltage to be increased from the current discharging completion voltage if the average amount of change in the charging impedance has decreased. The battery control unit 330 may set the next discharging completion voltage to be increased from the current discharging completion voltage by a preset rate in inverse proportion to the average amount of change in the charging impedance. For example, if the average amount of change in the charging impedance has decreased by 2%, the battery control unit 330 may reset the discharging completion voltage in the next cycle to a value increased by a rate of 0.2% from the discharging completion voltage in the current cycle, but is not limited thereto.

In some embodiments of the present disclosure, when the amount of change in the charging impedance increases, decreasing the discharging completion voltage may be for increasing the discharging capacity. This is because the actual discharging capacity will decrease if the discharging completion voltage in the current cycle and the discharging completion voltage in the next cycle are set to be equal when deterioration of the battery (increase in impedance) has occurred. Therefore, decreasing the discharging completion voltage can increase the discharging capacity to have a constant discharging capacity.

In contrast, when the amount of change in the charging impedance decreases, increasing the discharging completion voltage may be for reducing the discharging capacity. This is because the actual discharging capacity will increase if the discharging completion voltage in the current cycle and the discharging completion voltage in the next cycle are set to be equal when deterioration of the battery (decrease in impedance) has occurred. Therefore, increasing the discharging completion voltage can reduce the discharging capacity to have a constant discharging capacity.

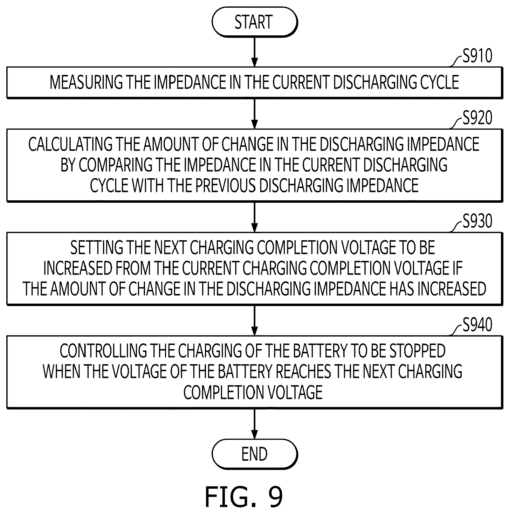

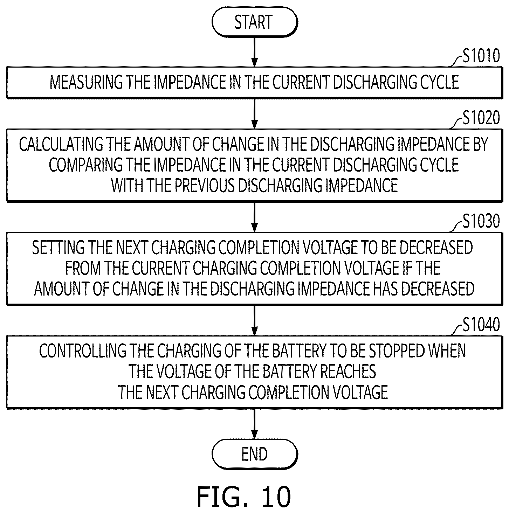

FIG. 9 and FIG. 10 are diagrams showing a method in which a battery management system sets a charging completion voltage according to embodiments of the present disclosure.

Referring to FIG. 9, the impedance measurement unit 310 may measure the impedance of the battery 400 in the current discharging cycle in step S910. For example, the impedance measurement unit 310 may measure the impedance of the battery 400 in preset frequency units immediately after the discharging is completed.

In step S920, the battery control unit 330 may calculate the amount of change in the discharging impedance by comparing the discharging impedance in the current discharging cycle with the discharging impedance in the previous discharging cycle. The battery control unit 330 may compare the magnitude of the impedance for each preset frequency of the current discharging cycle with the magnitude of the impedance for each preset frequency of the previous discharging cycle. The battery control unit 330 may calculate an average amount of change in the discharging impedance for each preset frequency.

In step S930, the battery control unit 330 may set the next charging completion voltage to be increased from the current charging completion voltage if the average amount of change in the discharging impedance has increased. The battery control unit 330 may set the next charging completion voltage to be increased from the current charging completion voltage by a preset rate in proportion to the average amount of change in the discharging impedance. For example, if the average amount of change in the discharging impedance has increased by 2%, the battery control unit 330 may reset the charging completion voltage in the next cycle to a value increased by a rate of 0.2% from the charging completion voltage in the current cycle, but is not limited thereto.

In step S940, the battery control unit 330 may control the charging of the battery 400 to be stopped when the voltage of the battery 400 reaches the next charging completion voltage. For example, the battery 400 may be charged again after the discharging is completed in the current cycle. The battery control unit 330 may control the charging operation of the battery 400 so that the charging of the battery 400 is stopped when the voltage of the battery 400 reaches the reset charging completion voltage.

Referring to FIG. 10, steps S1010, S1020, and S1040 are the same as steps S910, S920, and S940 described in FIG. 9, and thus, the overlapping descriptions will be omitted.

In step S1030, the battery control unit 330 may set the next charging completion voltage to be increased from the current charging completion voltage if the average amount of change in the discharging impedance has decreased. The battery control unit 330 may set the next charging completion voltage to be decreased from the current charging completion voltage by a preset rate in proportion to the average amount of change in the discharging impedance. For example, if the average amount of change in the discharging impedance has decreased by 2%, the battery control unit 330 may reset the charging completion voltage in the next cycle to a value decreased by a rate of 0.2% from the charging completion voltage in the current cycle, but is not limited thereto.

In some embodiments of the present disclosure, when the amount of change in the discharging impedance increases, increasing the charging completion voltage may be for increasing the charging capacity. This is because the actual charging capacity will decrease if the charging completion voltage in the current cycle and the charging completion voltage in the next cycle are set to be equal when deterioration of the battery (increase in impedance) has occurred. Therefore, increasing the charging completion voltage can increase the charging capacity to have a constant charging capacity.

In contrast, when the amount of change in the discharging impedance decreases, decreasing the charging completion voltage may be for reducing the charging capacity. This is because the actual charging capacity will increase if the charging completion voltage in the current cycle and the charging completion voltage in the next cycle are set to be equal when deterioration of the battery (decrease in impedance) has occurred. Therefore, decreasing the charging completion voltage can reduce the charging capacity to have a constant discharging capacity.

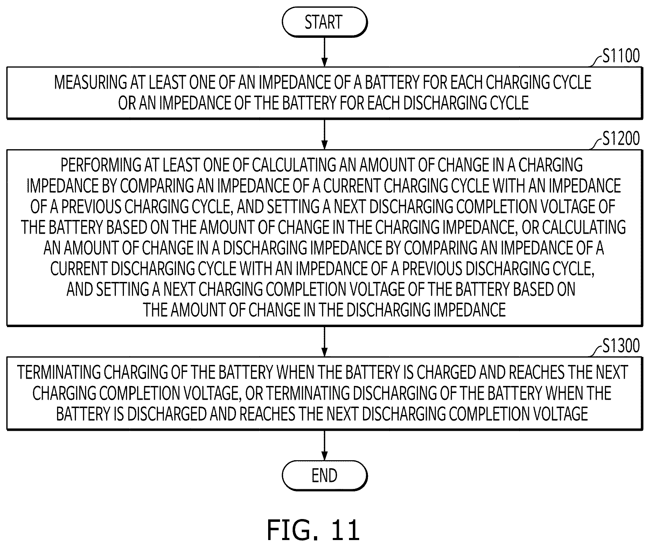

FIG. 11 is a diagram showing a battery management method according to embodiments of the present disclosure.

Referring to FIG. 11, the battery management method according to embodiments of the present disclosure may include measuring at least one of an impedance of a battery for each charging cycle or an impedance of the battery for each discharging cycle (S1100), performing at least one of calculating an amount of change in a charging impedance by comparing an impedance of a current charging cycle with an impedance of a previous charging cycle, and setting a next discharging completion voltage of the battery based on the amount of change in the charging impedance, or calculating an amount of change in a discharging impedance by comparing an impedance of a current discharging cycle with an impedance of a previous discharging cycle, and setting a next charging completion voltage of the battery based on the amount of change in the discharging impedance (S1200), and terminating charging of the battery when the battery is charged and reaches the next charging completion voltage, or terminating discharging of the battery when the battery is discharged and reaches the next discharging completion voltage (S1300).

In step S1100, the battery management system may measure impedances in preset frequency units through electrochemical impedance spectroscopy (EIS). For example, the battery management system may measure impedances in preset frequency units immediately after the battery is charged. As another example, the battery management system may measure impedances in preset frequency units immediately after the battery is discharged.

In step S1200, the battery management system may calculate the amount of change in the charging impedance by comparing the charging impedance in the current charging cycle with the charging impedance in the previous charging cycle, in embodiments. The battery management system may compare the magnitude of the impedance for each preset frequency of the charging cycle with the magnitude of the impedance for each preset frequency of the previous charging cycle. The battery management system may calculate an average amount of change in the amount of change in the impedance for each preset frequency.

The battery management system may set the next discharging completion voltage to be decreased from the current discharging completion voltage if the average amount of change in the charging impedance has increased. The battery management system may set the next discharging completion voltage to be decreased from the current discharging completion voltage by a preset rate in inverse proportion to the average amount of change in the charging impedance.

The battery management system may set the next discharging completion voltage to be increased from the current discharging completion voltage if the average amount of change in the charging impedance has decreased. The battery management system may set the next discharging completion voltage to be increased from the current discharging completion voltage by a preset rate in inverse proportion to the average amount of change in the charging impedance.

In step S1200, the battery management system may calculate the amount of change in the discharging impedance by comparing the discharging impedance in the current discharging cycle with the discharging impedance in the previous discharging cycle, in another embodiment. The battery management system may compare the magnitude of the impedance for each preset frequency of the current discharging cycle with the magnitude of the impedance for each preset frequency of the previous discharging cycle. The battery management system may calculate an average amount of change in the amount of change in the impedance for each preset frequency.

The battery management system may set the next charging completion voltage to be increased from the current charging completion voltage if the average amount of change in the discharging impedance has increased. The battery management system may set the next charging completion voltage to be increased from the current charging completion voltage by a preset rate in proportion to the average amount of change in the discharging impedance.

The battery management system may set the next charging completion voltage to be decreased from the current charging completion voltage if the average amount of change in the discharging impedance has decreased. The battery management system may set the next charging completion voltage to be decreased from the current charging completion voltage by a preset rate in proportion to the average amount of change in the discharging impedance.

In step S1300, the battery management system may control the discharging of the battery to be stopped when the voltage of the battery reaches the next discharging completion voltage, in embodiments. For example, the battery may be discharged again after the charging is completed in the current cycle. The battery management system may control the discharging operation of the battery so that the discharging of the battery is stopped when the voltage of the battery reaches the reset discharging completion voltage.

In step S1300, the battery management system may control the charging of the battery to be stopped when the voltage of the battery reaches the next charging completion voltage, in another embodiment. For example, the battery may be charged again after the discharging is completed in the current cycle. The battery management system may control the charging operation of the battery so that the charging of the battery is stopped when the voltage of the battery reaches the reset charging completion voltage.

Although the present disclosure has been described herein with respect to embodiments thereof, the present disclosure is not limited thereto. Various modifications and variations can be made thereto by those skilled in the art within the scope of the appended claims.

Embodiments are set out in the following numbered clauses:
1. A battery management system comprising:
   an impedance measurement unit configured to measure at least one of an impedance of a battery for each charging cycle or an impedance of the battery for each discharging cycle; and
   a battery control unit configured to perform at least one of calculating an amount of change in a charging impedance by comparing an impedance of a current charging cycle with an impedance of a previous charging cycle, and setting a next discharging completion voltage of the battery based on the amount of change in the charging impedance, or calculating an amount of change in a discharging impedance by comparing an impedance of a current discharging cycle with an impedance of a previous discharging cycle, and setting a next charging completion voltage of the battery based on the amount of change in the discharging impedance.
2. The battery management system of clause 1, wherein the impedance measurement unit measures impedances in preset frequency units by electrochemical impedance spectroscopy (EIS).
3. The battery management system of clause 2, wherein the battery control unit compares a magnitude of an impedance for each preset frequency of an impedance for each current charging cycle with a magnitude of an impedance for each impedance for each preset frequency of an impedance for each previous charging cycle, calculates an average amount of change in a charging impedance of an amount of change of an impedance for said each preset frequency, and sets the next discharging completion voltage based on the average amount of change in the charging impedance.
4. The battery management system of clause 3, wherein the battery control unit decreases the next discharging completion voltage if the average amount of change in the charging impedance has increased.
5. The battery management system of clause 4, wherein the battery control unit decreases the next discharging completion voltage by a preset rate from a current discharging completion voltage in inverse proportion to the average amount of change in the charging impedance.
6. The battery management system of any of clauses 3 to 5, wherein the battery control unit increases the next discharging completion voltage if the average amount of change in the charging impedance has decreased.
7. The battery management system of clause 6, wherein the battery control unit increases the next discharging completion voltage by a preset rate from a current discharging completion voltage in inverse proportion to the average amount of change in the charging impedance.
8. The battery management system of any of clauses 2 to 7, wherein the battery control unit compares a magnitude of an impedance for each preset frequency of an impedance for each current discharging cycle with a magnitude of an impedance for each impedance for each preset frequency of an impedance for each previous discharging cycle, calculates an average amount of change in a discharging impedance of an amount of change of an impedance for said each preset frequency, and sets the next charging completion voltage of the battery based on the average amount of change in the discharging impedance.
9. The battery management system of clause 8, wherein the battery control unit increases the next charging completion voltage if the average amount of change in the discharging impedance has increased.
10. The battery management system of clause 9, wherein the battery control unit increases the next charging completion voltage by a preset rate from a current discharging completion voltage in proportion to the average amount of change in the discharging impedance.
11. The battery management system of any of clauses 8 to 10, wherein the battery control unit decreases the next charging completion voltage if the average amount of change in the discharging impedance has decreased.
12. The battery management system of clause 11, wherein the battery control unit decreases the next charging completion voltage by a preset rate from a current discharging completion voltage in proportion to the average amount of change in the discharging impedance.
13. The battery management system of any preceding clause, wherein the battery control unit sets a first charging impedance of the battery measured when the battery is first charged after being shipped as a basic charging impedance, sets a voltage measured after the first charging is completed as a basic charging completion voltage, and sets the next charging completion voltage to be lower than the basic charging completion voltage.
14. The battery management system of any preceding clause, wherein the battery control unit sets a first discharging impedance of the battery measured when the battery is first discharged after being initially charged as a basic discharging impedance, sets a voltage measured after the first discharging is completed as a basic discharging completion voltage, and sets the next discharging completion voltage to be higher than the basic discharging completion voltage.
15. A method of managing a battery, comprising:
   measuring at least one of an impedance of a battery for each charging cycle or an impedance of the battery for each discharging cycle;
   performing at least one of calculating an amount of change in a charging impedance by comparing an impedance of a current charging cycle with an impedance of a previous charging cycle, and setting a next discharging completion voltage of the battery based on the amount of change in the charging impedance, or calculating an amount of change in a discharging impedance by comparing an impedance of a current discharging cycle with an impedance of a previous discharging cycle, and setting a next charging completion voltage of the battery based on the amount of change in the discharging impedance; and
   terminating charging of the battery when the battery is charged or reaches the next charging completion voltage, or terminating discharging of the battery when the battery is discharged or reaches the next discharging completion voltage.
16. The method of clause 15, wherein the measuring the impedance of the battery comprises:
   measuring impedances in preset frequency units by electrochemical impedance spectroscopy (EIS).
17. The method of clause 16, wherein the setting the next discharging completion voltage comprises:
   comparing a magnitude of an impedance for each preset frequency of an impedance for each current charging cycle with a magnitude of an impedance for each impedance for each preset frequency of an impedance for each previous charging cycle, calculating an average amount of change in a charging impedance of an amount of change of an impedance for said each preset frequency, and setting the next discharging completion voltage based on the average amount of change in the charging impedance.
18. The method of clause 17, wherein the setting the next discharging completion voltage comprises:
   decreasing the next discharging completion voltage if the average amount of change in the charging impedance has increased; and
   increasing the next discharging completion voltage if the average amount of change in the charging impedance has decreased.
19. The method of any of clauses 16 to 18, wherein the setting the next charging completion voltage comprises:
   comparing a magnitude of an impedance for each preset frequency of an impedance for each current discharging cycle with a magnitude of an impedance for each impedance for each preset frequency of an impedance for each previous discharging cycle, calculating an average amount of change in a discharging impedance of an amount of change of an impedance for said each preset frequency, and setting the next charging completion voltage of the battery based on the average amount of change in the discharging impedance.
20. The method of clause 19, wherein the setting the next charging completion voltage comprises:
   increasing the next charging completion voltage if the average amount of change in the discharging impedance has increased; and
   decreasing the next charging completion voltage if the average amount of change in the discharging impedance has decreased.

## Claims

1. A battery management system (300) comprising:
an impedance measurement unit (310) configured to measure at least one of an impedance of a battery (400) for each charging cycle or an impedance of the battery (400) for each discharging cycle; and
a battery control unit (330) configured to perform at least one of calculating an amount of change in a charging impedance by comparing an impedance of a current charging cycle with an impedance of a previous charging cycle, and setting a next discharging completion voltage of the battery (400) based on the amount of change in the charging impedance, or calculating an amount of change in a discharging impedance by comparing an impedance of a current discharging cycle with an impedance of a previous discharging cycle, and setting a next charging completion voltage of the battery (400) based on the amount of change in the discharging impedance.

2. The battery management system (300) as claimed in claim 1, wherein the impedance measurement unit (310) is configured to measure impedances in preset frequency units by electrochemical impedance spectroscopy (EIS).

3. The battery management system (300) as claimed in claim 2, wherein the battery control unit (330) is configured to:
compare a magnitude of an impedance for each preset frequency of an impedance for each current charging cycle with a magnitude of an impedance for each impedance for each preset frequency of an impedance for each previous charging cycle;
calculate an average amount of change in a charging impedance of an amount of change of an impedance for said each preset frequency; and
set the next discharging completion voltage of the battery (400) based on the average amount of change in the charging impedance.

4. The battery management system (300) as claimed in claim 3, wherein the battery control unit (330) is configured to decrease the next discharging completion voltage by a preset rate from a current discharging completion voltage in inverse proportion to the average amount of change in the charging impedance if the average amount of change in the charging impedance has increased.

5. The battery management system (300) as claimed in claim 3 or claim 4, wherein the battery control unit (330) is configured to increase the next discharging completion voltage by a preset rate from a current discharging completion voltage in inverse proportion to the average amount of change in the charging impedance if the average amount of change in the charging impedance has decreased.

6. The battery management system (300) as claimed in any of claims 2 to 5, wherein the battery control unit (330) is configured to:
compare a magnitude of an impedance for each preset frequency of an impedance for each current discharging cycle with a magnitude of an impedance for each impedance for each preset frequency of an impedance for each previous discharging cycle;
calculate an average amount of change in a discharging impedance of an amount of change of an impedance for said each preset frequency; and
set the next charging completion voltage of the battery (400) based on the average amount of change in the discharging impedance.

7. The battery management system (300) as claimed in claim 6, wherein the battery control unit (330)is configured to increase the next charging completion voltage by a preset rate from a current discharging completion voltage in proportion to the average amount of change in the discharging impedance if the average amount of change in the discharging impedance has increased.

8. The battery management system (300) as claimed in claim 6 or claim 7, wherein the battery control unit (330) is configured to decrease the next charging completion voltage by a preset rate from a current discharging completion voltage in proportion to the average amount of change in the discharging impedance if the average amount of change in the discharging impedance has decreased.

9. The battery management system (300) as claimed in any preceding claim, wherein the battery control unit (330) is configured to:
set a first charging impedance of the battery (400) measured when the battery (400) is first charged after being shipped as a basic charging impedance;
set a voltage measured after the first charging is completed as a basic charging completion voltage; and
set the next charging completion voltage to be lower than the basic charging completion voltage.

10. The battery management system (300) as claimed in any preceding claim, wherein the battery control unit (330) is configured to:
set a first discharging impedance of the battery (400) measured when the battery (400) is first discharged after being initially charged as a basic discharging impedance;
set a voltage measured after the first discharging is completed as a basic discharging completion voltage; and
set the next discharging completion voltage to be higher than the basic discharging completion voltage.

11. A method of managing a battery (400), comprising:
measuring at least one of an impedance of a battery (400) for each charging cycle or an impedance of the battery (400) for each discharging cycle, wherein the measuring the impedance of the battery (400) comprises measuring impedances in preset frequency units by electrochemical impedance spectroscopy (EIS);
performing at least one of calculating an amount of change in a charging impedance by comparing an impedance of a current charging cycle with an impedance of a previous charging cycle, and setting a next discharging completion voltage of the battery (400) based on the amount of change in the charging impedance, or calculating an amount of change in a discharging impedance by comparing an impedance of a current discharging cycle with an impedance of a previous discharging cycle, and setting a next charging completion voltage of the battery (400) based on the amount of change in the discharging impedance; and
terminating charging of the battery (400) when the battery (400) is charged or reaches the next charging completion voltage, or terminating discharging of the battery (400) when the battery (400) is discharged or reaches the next discharging completion voltage.

12. The method as claimed in claim 11, wherein the setting the next discharging completion voltage comprises:
comparing a magnitude of an impedance for each preset frequency of an impedance for each current charging cycle with a magnitude of an impedance for each impedance for each preset frequency of an impedance for each previous charging cycle;
calculating an average amount of change in a charging impedance of an amount of change of an impedance for said each preset frequency; and
setting the next discharging completion voltage based on the average amount of change in the charging impedance.

13. The method as claimed in claim 12, wherein the setting the next discharging completion voltage comprises:
decreasing the next discharging completion voltage if the average amount of change in the charging impedance has increased; and
increasing the next discharging completion voltage if the average amount of change in the charging impedance has decreased.

14. The method as claimed in claim 11, wherein the setting the next charging completion voltage comprises:
comparing a magnitude of an impedance for each preset frequency of an impedance for each current discharging cycle with a magnitude of an impedance for each impedance for each preset frequency of an impedance for each previous discharging cycle;
calculating an average amount of change in a discharging impedance of an amount of change of an impedance for said each preset frequency; and
setting the next charging completion voltage of the battery (400) based on the average amount of change in the discharging impedance.

15. The method as claimed in claim 14, wherein the setting the next charging completion voltage comprises:
increasing the next charging completion voltage if the average amount of change in the discharging impedance has increased; and
decreasing the next charging completion voltage if the average amount of change in the discharging impedance has decreased.
